# EUROPEAN PATENT APPLICATION

(11) **EP 2 517 779 A1**
(43) Date of publication of application: **31.10.2012**
(21) Application number: 11163690.8
(22) Date of filing: 26.04.2011
(51) Int. Cl.: B01D 69/10, B01D 71/02, B01D 67/00, C23C 14/56

(54) **Nanosieve composite membrane**

(71) Applicant: Nederlandse Organisatie voor Toegepast -Natuurwetenschappelijk Onderzoek TNO, 2628 VK Delft (NL)
(72) Inventor: Unnikrishnan, Sandeep, 2628 VK Delft (NL); Young, Edward Willem Albert, 2628 VK Delft (NL)
(74) Representative: Jansen, Cornelis Marinus

(57) **Abstract**

The invention is directed to a nanosieve composite membrane, a method for preparing a nanosieve composite membrane, a roll-to-roll apparatus for carrying out the method, and a method for separating a feed flow with particulate matter.

The nanosieve composite of the invention comprises an inorganic nanosieve membrane supported on a porous polymer membrane substrate, wherein said polymer membrane substrate comprises an inorganic coating.

## Description

The invention is directed to a nanosieve composite membrane, a method for preparing a nanosieve composite membrane, a roll-to-roll apparatus for carrying out the method, and a method for separating a feed flow with particulate matter.

Membranes are widely used in various industrial processes, such as in the field of fluid filtration, gas separation, air cleaning, membrane-reactors *etc.* By tuning their structural morphology and material composition, membranes can be applied for different purposes. Membranes are usually fabricated porous or dense using organic (*e.g.* polymer) and/or inorganic (*e.g.* ceramic) materials. Permeation through membranes usually functions by a pore-based diffusion phenomenon or a solution-diffusion phenomenon depending on their structural morphology.

Fluid filtration can be done based on various characteristics of the particles to be separated like charge, adsorptivity, size, mass, *etc.,* of which size based filtration is the most preferred due to its simplicity and effectiveness. Usually ceramic membranes are most successfully used for filtration (made of e.g. alumina), but have a random porosity with a broad pore-size distribution and also have a multitude of tortuous and dead-end pores.

A solution to this problem is the use of thin, geometrically defined ceramic sieves (microsieve or nanosieve), which have circular non-tortuous perforations with a pre-determined size-distribution and porosity. Moreover, they also have a controllable uniform thickness down to a few tens of nanometers.

Although microsieves (with a pore size defined by a pore diameter of about 2-10 µm) can be fabricated in various ways, the fabrication of nanosieves (with a pore-size of less than 200 nm) is not trivial. Both micro and nanosieves can be fabricated using polymers (Vogelaar et al., Advanced Materials 2003, 15(16), 1385-1389 and Vlassiouk et al., Proceedings of the National Academic Sciences of the United States of America 2009, 106(50), 21039-21044), but they suffer from fouling, swelling, and non-resistance to specific chemicals that are used in filtration processes. Moreover, self-standing polymer nanosieves need to have a thickness in the micrometer scale (or more) for sufficient mechanical strength, but this increases the flow resistance through them.

WO-A-2006/119915 describes a polymeric membrane having a pore diameter in the range of 0.1-100 nm supported by a carrier membrane having a pore diameter of 1-500 µm.

Inorganic nanosieve membranes on the other hand do not have the aforementioned drawbacks. They can be made very thin, strong and chemically stable. Currently, the fabrication of inorganic nanosieves is limited to a silicon wafer based micromachining confined to clean room processing, which makes it expensive and thus hinders its wide applicability. The industrial scalability of inorganic nanosieve production is crucial for cost reduction and to widen its application base.

US-A-5 968 326 describes a composite membrane comprising an inorganic ion-conducting layer on a cation-selective organic polymer membrane substrate. As possible material for the inorganic ion-conducting layer, this document mentions zeolites.

US-A-2005/0 070 193 describes a sheetlike flexible non-woven substrate having a multiplicity of openings and having a ceramic porous coating. This document further describes the possibility of pre-coating the non-woven with a metal oxide or organosilane adhesion promoter.

US-A-2009/0 069 616 discloses composite membranes comprising a molecular sieve on a polymeric support. The support can have pores or openings in the range of 2 to 100, preferably 20 to 50 nm.

There remains a need in the art for nanosieves that can be successfully used for filtration and can easily be produced.

Objective of the invention is to provide a nanosieve that overcomes at least part of the problems faced in the prior art.

Further objective of the invention is to provide a nanosieve composite with a polymer membrane support that is protected from degrading (such as in aggressive fluids).

The inventors found that one or more of these objectives can at least partially be met by supporting an inorganic nanosieve layer on a protected porous polymeric support.

Hence, in a first aspect, the invention is directed to a nanosieve composite comprising an inorganic nanosieve layer supported on a porous polymer membrane substrate, wherein said polymer membrane comprises an inorganic coating.

The nanosieve composite of the invention provides a geometrically patterned inorganic thin-film nanosieve supported on a macroporous polymer membrane. To protect the polymer support from degrading (such as in aggressive fluids), the polymer support is encapsulated in a protective coating. This inorganic-polymer-inorganic sandwich design combines the advantages of the inorganic nanostructured thin-film (such as precise pore definition, ultrathin selective layer, nanoscale robustness and chemical inertness) with the advantages of the polymer support membrane (such as flexibility, rollability, cheapness and industrial scalability. The nanosieve composite is therefore not only useful for air filtration, but also for liquid filtration processes.

The inorganic nanosieve layer can be a ceramic nanosieve layer. Suitable ceramic materials include silicon nitride (Si₃N₄), SiO₂, and Al₂O₃. The inorganic nanosieve layer can also be a metal (or alloy) nanosieve comprising one or more from the group consisting of chromium, copper, tin, nickel and aluminium.

The average pore diameter of the inorganic nanosieve layer as determined by bubble porosimetry can be of 200 nm or less, such as 150 nm or less, preferably 100 nm or less. From a practical point of view, the average pore size of the nanosieve is preferably 1 nm or more, such as 2 nm or more, or 5 nm or more.

Suitably, the inorganic nanosieve layer is applied as a thin film on the polymer membrane support. The inorganic nanosieve layer can, for example, have a thickness in the range of 10-200 nm, such as in the range of 20-150 nm, or in the range of 50-100 nm. Layer thicknesses as defined herein can be determined by techniques well-known to the person skilled in the art, including DekTak profilometry or HR-SEM (high resolution scanning electron microscopy).

The polymer membrane support can suitably be a polymer support. Suitable materials for the polymer membrane include polyethylene naphthalate (PEN), polyethylene terephthalate (PET), polyimide or any other polymer, and any mixtures thereof. In order to provide sufficient mechanical support, the polymer membrane support typically has a thickness of at least 1 µm, preferably at least 2 µm more preferably at least 5 µm. From a practical point of view it is not desirable to use a polymer membrane support having a thickness of more than 100 µm. The applied polymer membrane support can advantageously be derived from a polymer foil or web.

Preferably, the polymer membrane support is porous. The average pore diameter of a porous polymer membrane as determined by bubble porosimetry can suitably be in the range of 1-20 µm, such as in the range of 2-10 µm. Alternatively (or in addition to pores), the polymer membrane support can have periodic grooves or channels. In case the polymer membrane support has grooves or channels, the average groove or channel width is preferably in the range of 1-20 µm, such as in the range of 2-10 µm.

The polymer membrane support in the nanosieve composite of the invention further comprises an inorganic coating. This inorganic coating may be in direct contact with the polymer membrane support. In an embodiment the coverage of the inorganic coating on the polymer membrane is such that essentially no surface of the polymer membrane is exposed after the coating has been applied. This does not necessarily mean that the inorganic coating entirely covers the polymer membrane. In a special embodiment, the polymer membrane support is provided with a further protective coating (such as an adhesion layer as explained below) that covers parts of the polymer membrane support that are not covered by the inorganic coating.

The inorganic coating may have a thickness in the range of 1-200 nm, such as in the range of 5-150 nm, or in the range of 10-100 nm. These thicknesses are suitable for providing sufficient protection to the polymer membrane.

Suitably, the material of the inorganic coating is the same as the material of the inorganic nanosieve layer. Hence, in a preferred embodiment, the inorganic coating is a ceramic coating, such as a silicon nitride coating. Other materials that may be used for the inorganic coating include metals or alloys. The inorganic coating may therefore also comprise one or more selected from the group consisting of chromium, copper, tin, nickel and aluminium.

In a special embodiment the nanosieve composite of the invention further comprises an adhesion layer between the inorganic nanosieve layer and the polymer membrane support. This layer may serve to improve the adhesion of the inorganic nanosieve layer onto the polymer membrane support (which is preferably organic) and/or to provide additional protection to the polymer membrane support (such as against aggressive fluids).

Suitably, the adhesion layer can be a metal layer. The adhesion layer can comprise one or more selected from the group consisting of tantalum, chromium, titanium, and molybdenum.

The optional adhesion layer can have a layer thickness in the range of 1-100 nm, such as in the range of 2-70 nm or in the range of 5-50 nm.

In a further aspect, the invention is directed to a method for preparing a nanosieve composite, preferably one as defined hereinabove, comprising (preferably in the indicated sequence) the steps of
a) providing a polymer substrate;
b) optionally depositing an adhesion layer onto said polymer substrate;
c) depositing a first layer of inorganic material onto said polymer substrate or onto said optional adhesion layer;
d) perforating said polymer substrate;
e) optionally removing part of the adhesion layer that is exposed;
f) depositing a second layer of inorganic material on the side opposite of said first layer of inorganic material onto said perforated polymer;
g) coating a photoresist on the first layer of inorganic material;
h) generating a nanosieve pattern on the photoresist;
i) transferring the nanosieve pattern into the inorganic layer; and
j) removing photoresist.

As a polymer substrate a non-porous polymer foil can be applied. The polymer materials can be as defined hereinabove. Optionally, an adhesion layer is deposited on the polymer substrate. The adhesion layer can, for instance, be deposited on the polymer substrate by an evaporation technique.

In step c) a first layer of inorganic material is deposited onto the polymer substrate or alternatively onto the optional adhesion layer. This can suitably comprise a vapour deposition technique (including physical vapour deposition and chemical vapour deposition), such as plasma enhanced chemical vapour deposition. Plasma enhanced chemical vapour deposition has the advantage that a relatively low processing temperature of about 100 °C can be employed.

Perforation of the polymer substrate in step d) may be performed by laser ablation, such as pulsed laser ablation. In accordance with this step the polymer substrate is rendered porous. The perforation of the polymer substrate may result in the polymer substrate having pores, grooves, and/or channels.

In optional step e), part of the adhesion layer that is exposed (on the polymer substrate side) after the polymer perforation is removed. In practice, steps d) and e) may be performed in a single step, for instance, by laser ablation. Alternatively, part of the adhesion layer can be removed by an etching process, such as plasma etching. Preferably, the part of the adhesion layer that is exposed by removal of the polymer perforation is removed in optional step e).

In an embodiment the polymer is perforated after which the optional adhesion layer is applied onto the perforated polymer. Subsequently, part of the adhesion layer in the perforated polymer is removed to expose the first layer of inorganic material in the polymer perforations.

In step f) of the method, a second layer of inorganic material is deposited on the side opposite of the first layer of inorganic material onto said perforated polymer. Advantageously, the same type of inorganic material could be deposited in steps c) and f). Deposition of the inorganic material in step f) can again be suitably performed using a vapour deposition technique (including physical vapour deposition and chemical vapour deposition), such as plasma enhanced chemical vapour deposition.

A photoresist is applied onto the first layer of inorganic material. Various kinds of suitable photoresists are well-known in the field of lithography. Both positive photoresists, as well as negative photoresists may be employed. Preferably, the photoresist is an ultraviolet sensitive resist. A suitable technique for applying the photoresist onto the first layer of inorganic material is by coating such as from coating apparatus, such as a slot-die coater. However, the photoresist can also be applied using a printing process. Typically, the thickness of the photoresist layer is in the range of 50-500 nm, such as in the range of 100-300 nm or 150-250 nm.

After the photoresist has been applied onto the first layer of inorganic material a nanosieve pattern is generated in the photoresist. This may for example be done by lithography techniques, such as nanoimprint lithography or laser-interference lithography.

The generated nanosieve pattern is thereafter transferred into the first layer of inorganic material in step i). A suitable technique for carrying out this step is by etching, such as plasma etching and/or chemical etching. Plasma etching can, for example, involve a CF₄+O₂ mixed mode plasma.

Upon having transferred the nanosieve pattern into the first layer of inorganic material, the photoresist can be removed. This may also be done using a plasma technique, such as using an O₂ plasma.

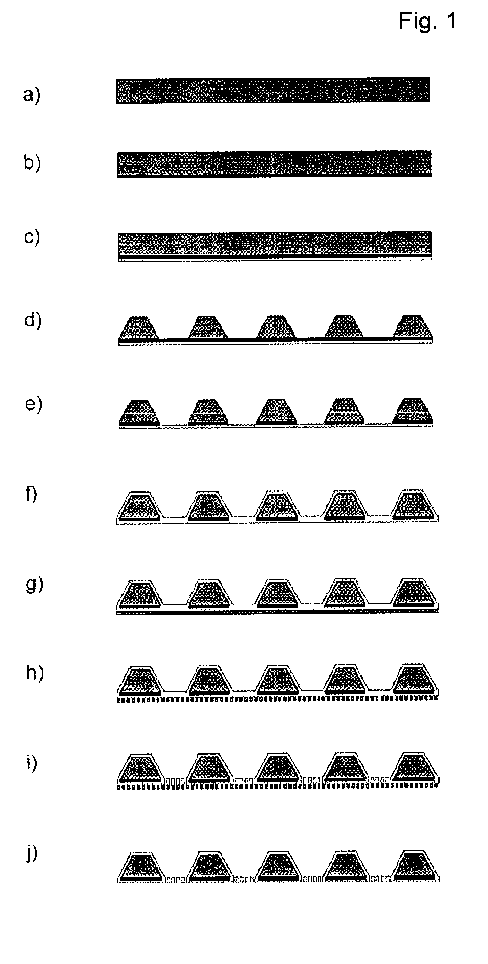

The method of the invention is further clarified by figure 1 which shows a two-dimensional cross-sectional representation of the method of the invention for preparing a nanosieve composite.

Advantageously this method can be performed using the roll-to-roll approach. This allows an easy and quick fabrication of the nanosieve composites of the invention. Moreover, it enables mass-production.

Hence, in a further aspect the invention is directed to an apparatus for manufacturing composite nanosieve membranes, preferably by carrying out the method of the invention.

The apparatus of the invention comprises
- a substrate supply for supplying a continuous substrate web, for instance a polymer substrate, in a supplying direction;
- a first deposition unit downstream of the substrate supply for depositing a first layer of inorganic material onto a first surface of the substrate when the substrate is passing said unit in said supplying direction;
- a laser ablator, provided downstream of the first deposition unit, and arranged to face a second surface of the substrate, opposite the first surface, which laser ablator is configured to remove at least part of the substrate material;
- at least one further deposition unit downstream of the substrate supply for depositing a second layer of inorganic material onto the second surface of the substrate when the substrate is passing said further provision in said supplying direction.
- a coating device, such as a slot-die coating device, provided downstream of the respective first or second deposition unit for coating a photo resist layer onto one of the first and second substrate surfaces;.
- an imprinting device arranged downstream of the coating device, for imprinting a nanosieve pattern into the photo resist layer; and
- an etching device arranged downstream the imprinting device for transferring said nanosieve pattern from the photo resist layer into the inorganic layer.

The first deposition unit can deposit a first layer of inorganic material onto on surface of the substrate, while the further deposition unit can deposit a second layer of inorganic material on the opposite surface of the substrate. This allows a protection of the substrate by the inorganic material on both surfaces of the substrate.

The apparatus can comprise a third deposition unit, for instance an evaporator, arranged upstream of the first or second deposition unit, for applying a thin metal layer on the first or second substrate surface before applying said inorganic material layer onto said first or second substrate surface. This thin metal layer can, for instance, be an adhesion layer as described herein. Alternatively, the adhesion layer can be applied by the first deposition unit.

Preferably, the apparatus is a roll-to-roll apparatus, wherein the apparatus comprises a substrate rewinding system for rewinding the processed substrate, wherein both, the substrate supply and the substrate receiver comprise a frame for rotatably holding a roll of continuous substrate web.

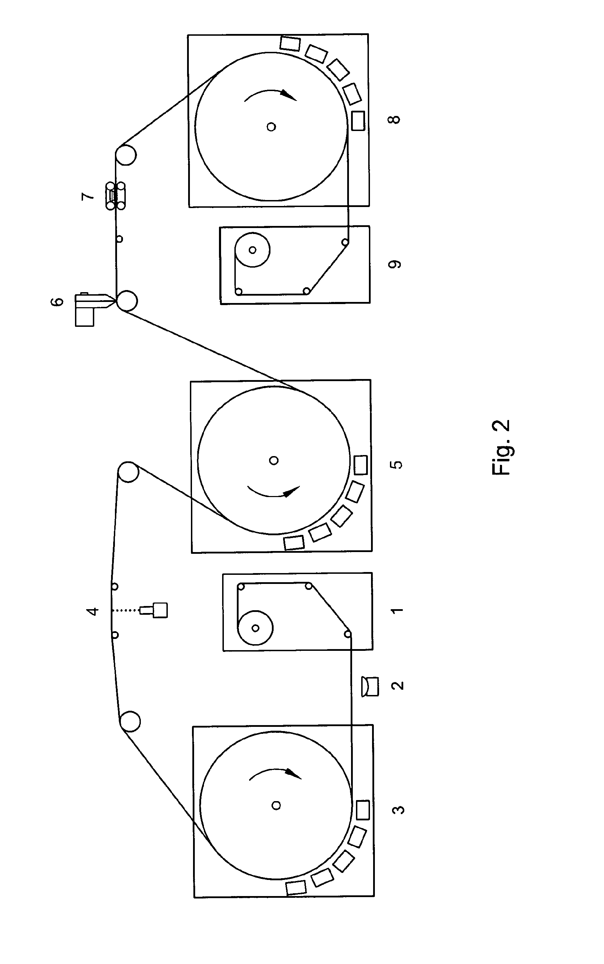

An example of such a roll-to-roll apparatus is shown in Figure 2. In this example, an unwinding system 1 supplies a continuous polymer substrate web. The polymer substrate web passes an evaporator 2, which can evaporate a thin (such as about 10 µm thick) metallic (such as tantalum) layer on top of the polymer substrate web. The web then passes a plasma enhanced chemical vapour deposition system 3, wherein an inorganic (such as a ceramic) layer can be deposited. Subsequently, the back side of the web is ablated using a pulsed laser source 4 to form grooves or channels in the polymer web. During this ablation, the metallic layer is also removed inside the areas exposed by the vias (stopping on the inorganic layer). Optionally, metals like tantalum can also be removed by plasma etching. Subsequently, a second inorganic layer (such as a ceramic layer) is deposited on the back side of the web using another plasma enhanced vapour deposition system 5. Then, a slot-die coater 6 (or any other suitable coating or printing device) is used to coat the web with an ultraviolet light sensitive resist, after which a rolling nanoimprint lithography 7 is done to create the nanosieve pattern on the resist layer. Subsequently, the nanosieve pattern in transferred into the silicon nitride layer using plasma etching 8 and the resist is stripped in oxygen plasma. Finally, the processed polymer web is rewinded using rewinding system 9.

The nanosieve composites of the invention can advantageously be employed in filtration processes, such as an air/gas filtration process, or a liquid filtration process. In particular, the nanosieve composites of the invention are suitable for a liquid filtration process.

Accordingly, in a further aspect the invention is directed to a method for separating a feed flow with particulate matter comprising passing the feed flow over a nanosieve composite of the invention.

When the feed flow with the contaminants is passed over the nanosieve composite of the invention, a permeate (or filtrate) flow will pass through the nanosieve composite, while retentate containing contaminants that are incapable of passing through the nanosieve will remain at the feed side of the nanosieve composite. Due to the flexibility of the polymer membrane support, it may be preferable to provide a macroporous rigid surface for further support.

A specific selection of the polymer membrane support further allows a dual separation. For example, the inorganic nanosieve layer provides a size exclusion, while the polymer membrane support provides an exclusion based on size, hydrophilicity, charge, and the like. Such dual separation is advantageous for decreasing the amount of steps in separation processes.

The invention will hereafter be illustrated by means of the following examples, which are not intended to limit the invention in any way.

## Claims

1. Nanosieve composite comprising an inorganic nanosieve layer supported on a porous polymer membrane substrate, wherein said polymer membrane comprises an inorganic coating.

2. Nanosieve composite according to claim 1, wherein said inorganic nanosieve layer has an average pore diameter as determined by bubble porosimetry of 200 nm or less.

3. Nanosieve composite according to claim 1 or 2, wherein the coverage of said inorganic coating is such that essentially no surface of the polymer membrane is exposed.

4. Nanosieve composite according to claims 3, wherein said inorganic coating has a thickness in the range of 1-200 nm, such as in the range of 5-150 nm, or in the range of 10-100 nm.

5. Nanosieve composite according to any one of claims 1-4, comprising an adhesion layer between the inorganic nanosieve layer and the polymer membrane substrate.

6. Nanosieve composite according to claim 5, wherein said adhesion layer is a metallic layer, preferably having a thickness in the range of 1-100 nm, such as in the range of 2-70 nm or in the range of 5-50 nm.

7. Nanosieve composite according to any one of claims 1-6, wherein the polymer membrane is porous, and preferably has an average pore diameter as determined by bubble porosimetry in the range of 1-20 µm, such as in the range of 2-10 µm.

8. Nanosieve composite according to any one of claims 1-7, wherein said polymer membrane substrate has a thickness in the range of 1-100 µm, such as in the range of 20-70 µm, preferably in the range of 40-50 µm.

9. Nanosieve composite according to any one of claims 1-8, wherein said inorganic nanosieve layer has a thickness in the range of 10-200 nm, such as in the range of 20-100 nm, preferably in the range of 30-70 nm.

10. Method of preparing a nanosieve composite, preferably according to any one of claims 1-9, comprising:
a) providing a polymer substrate;
b) optionally depositing an adhesion layer onto said polymer substrate;
c) depositing a first layer of inorganic material onto said polymer substrate or onto said optional adhesion layer;
d) perforating said polymer substrate;
e) optionally removing part of the adhesion layer that is exposed;
f) depositing a second layer of inorganic material on the side opposite of said first layer of inorganic material onto said perforated polymer;
g) coating a photoresist on the first layer of inorganic material;
h) generating a nanosieve pattern on the photoresist;
i) transferring the nanosieve pattern into the inorganic layer; and
j) removing photoresist.

11. Method according to claim 10, wherein step b) comprises physical vapour deposition, wherein steps c) and f) comprise chemical vapour deposition, wherein steps d) and e) comprise laser ablation, wherein step h) comprises imprinting lithography, and/or wherein steps i) and j) comprise etching.

12. Method according to any one of claims 10 or 11 performed in a roll-to-roll fabrication method.

13. Apparatus for manufacturing composite nanosieve membranes, preferably by carrying out the method according to any one of claims 10-12, the apparatus comprising;
- a substrate supply for supplying a continuous substrate web, for instance a polymer substrate, in a supplying direction;
- a first deposition unit downstream of the substrate supply for depositing a first layer of inorganic material onto a first surface of the substrate when the substrate is passing said unit in said supplying direction;
- a laser ablator, provided downstream of the first deposition unit, and arranged to face a second surface of the substrate, opposite the first surface, which laser ablator is configured to remove at least part of the substrate material;
- at least one further deposition unit downstream of the substrate supply for depositing a second layer of inorganic material onto the second surface, of the substrate when the substrate is passing said further provision in said supplying direction;
- a coating device, such as a slot-die coating device, provided downstream of the respective first or second deposition unit for coating a photo resist layer onto one of the first and second substrate surfaces;
- an imprinting device arranged downstream of the coating device, for imprinting a nanosieve pattern into the photo resist layer; and
- an etching device arranged downstream the imprinting device for transferring said nanosieve pattern from the photo resist layer into the inorganic layer.

14. Apparatus according to claim 13, wherein the apparatus comprises a third deposition unit, for instance an evaporator, arranged upstream of the first or second deposition unit, for applying a thin metal layer on the first or second substrate surface before applying said inorganic material layer onto said first or second substrate surface.

15. Apparatus according to claim 13 or 14, wherein the apparatus is a roll-to-roll apparatus, wherein the apparatus comprises a substrate rewinding system for rewinding the processed substrate, wherein both, the substrate supply and the substrate rewinding system comprise a frame for rotatably holding a roll of continuous substrate web.

16. Method of separating a feed flow with particulate matter comprising passing the feed flow over a nanosieve composite according to any one of claims 1-9.
